# EUROPEAN PATENT APPLICATION

(11) **EP 1 437 624 A1**
(43) Date of publication of application: **14.07.2004**
(21) Application number: 04250064.5
(22) Date of filing: 08.01.2004
(51) Int. Cl.: G03F 7/00, G03F 7/038

(54) **Stereolithographic resins containing selected oxetane compounds**

(30) Priority: 13.01.2003 US 342408
(71) Applicant: 3D SYSTEMS, INC., Valencia, California 91355 (US)
(72) Inventor: Steinmann, Bettina, 1724 Praroman (CH)
(74) Representative: Nunney, Ronald Frederick Adolphe

(57) **Abstract**

A liquid radiation-curable composition that comprises
(A) at least one cationically polymerizing organic substance;
(B) at least one free-radical polymerizing organic substance;
(C) at least one cationic polymerization initiator;
(D) at least one free-radical polymerization initiator;
(E) at least one hydroxyl-functional compound; and
(F) at least one hydroxyl-functional oxetane compound;

## Description

### BACKGROUND OF THE INVENTION

### 1. Field of the Invention

The present invention relates to selected stereolithographic resins containing oxetane compounds. In particular, this invention relates to stereolithographic resins that give an exceptionally high photospeed with high green strength. Also, these resins of the present invention have low viscosity, low humidity-sensitivity and high temperature resistance.

### 2. Brief Description of Art

The production of three-dimensional articles of complex shape by means of stereolithography has been known for a relatively long time. In this technique the desired shaped article is built up from a liquid, radiation-curable composition with the aid of a recurring, alternating sequence of two steps (a) and (b); in step (a), a layer of the liquid, radiation-curable composition, one boundary of which is the surface of the composition, is cured with the aid of appropriate radiation, generally radiation produced by a preferably computer-controlled laser source, within a surface region which corresponds to the desired cross-sectional area of the shaped article to be formed, at the height of this layer, and in step (b) the cured layer is covered with a new layer of the liquid, radiation-curable composition, and the sequence of steps (a) and (b) is repeated until a so-called green model of the desired three-dimensional shape is finished. This green model is, in general, not yet fully cured and must therefore, normally, be subjected to post-curing.

The mechanical strength of the green model (modulus of elasticity, fracture strength), also referred to as green strength, constitutes an important property of the green model and is determined essentially by the nature of the stereolithographic-resin composition employed. Other important properties of a stereolithographic resin composition include a high sensitivity for the radiation employed in the course of curing and a minimum curl factor, permitting high shape definition of the green model.
In addition, for example, the precured material layers should be readily wettable by the liquid stereolithographic resin composition, and of course not only the green model but also the ultimately cured shaped article should have optimum mechanical properties.

In order to achieve the desired balance of properties, different types of resin systems have been proposed. For example, radical-curable resin systems have been proposed. These systems generally consist of one or more (meth)acrylate compounds (or other free-radical polymerizable organic compounds) along with a free-radical photoinitiator for radical generation. U.S. Patent No. 5,418,112 describes one such radical-curable system.

Another type of resin composition suitable for this purpose is a dual type system that comprises (i) epoxy resins or other types of cationic polymerizable compounds; (ii) cationic polymerization initiator; (iii) acrylate resins or other types of free radical polymerizable compounds; and (iv) a free radical polymerization initiator. Examples of such dual or hybrid systems are described in U.S. Patent No. 5,434,196.

A third type of resin composition useful for this application also includes (v) hydroxyl-containing compounds such as polyether-polyols. Examples of such hybrid systems are described in U.S. Patent Nos. 5,972,563; 6,100,007 and 6,287,748.

Separately, oxetane compounds have been suggested as components for stereolithographic resins and other radiation-curable resins. They have been suggested as either a cationically polymerizing organic substance or as a reactive modifier component for such resins.

Several references teach the use of oxetane compounds in radiation curable resin compositions, including the following:

U.S. Patent Nos. 5,434,196 and 5,525,645 (Ohkawa et al) are directed to resin composition for optical molding which comprises (A) an actinic radiation-curable and cationically polymerizable organic substance and (B) an actinic radiation-sensitive initiator for cationic polymerization. Component (A) may be either epoxy compounds, oxetane compounds or mixtures thereof.

U.S. Patent No. 5,674,922 (Igarashi et al) teach active energy beam-curable compositions which comprises (A) at least one oxetane compound (B) at least one epoxide compound and (C) at least one cationic initiator.

U.S. Patent No. 5,981,616 (Yamamura et al.) teaches photo curable compositions that contain (A) an oxetane compound (B) one or more selected epoxy compounds and (C) a cationic photo-initiator. The selected epoxy compounds (B) include (i) epoxidized polymers of conjugated diene monomers; (ii) epoxidized copolymers of conjugated diene monomers, (iii) epoxidized copolymers of conjugated diene monomers and compounds having ethylenically unsaturated bond; and (ix) epoxidized natural rubber. This '616 Patent states that this photocurable resin composition is capable of being promptly cured by photo-irradiation, thereby reducing fabricating time and providing cured products having excellent mechanical strength and minimized shrinkage during curing to ensure high dimensional accuracy.

U.S. Patent No. 6,127,085 (Yamamura et al.) teaches a photo-curable composition comprising (A) a specific epoxy compound having a cyclohexane oxide; (B) a cationic photo-initiator; (C) a specific ethylenically unsaturated monomer; (D) a radical photo-initiator; and (E) a polyol. In addition, to those five critical ingredients, other cationically polymerizable organic compounds other than component (A) may be additionally present, these may include oxetane compounds. See column 10, lines 2 to 17 and column 10, lines 49-53 of this '085 Patent.

U.S. Patent No. 6,136,497 (Melisaris et al).teaches a method for producing three-dimensional shaped articles with a radiation-curable composition containing (A) 20-90% by weight of cationically polymerizing compounds; (B) 0.05-12% by weight of cationic initiator; and (C) 0.5-60% by weight of at least selected cationic reactive modifiers. Oxetane compounds may be used either as the cationically polymerizable organic substance (A) or may be used as the cationic reactive modifiers; (B); see column 3, line 41 and column 8, lines 4 to 7; and column 17, lines 54 to 56 of the '497 patent.

U.S. Patent No. 6,365,644 (Yamamura et al) teaches a process for photo-fabricating a three-dimensional object by selectively curing a photo-curable resin composition comprising (A) an oxetane; (B) an epoxy compound; and (C) a cationic photo-initiator. The preferred epoxy compounds in this patent are glycidyl esters of fatty acids, epoxidated soybean oil, and epoxidated linseed oil. This '644 patent is a continuation of the above-described '616 patent.

U.S. Patent No. 6,368,769 (Ohkawa et al.) teaches a stereolithographic resin composition that may include mixtures of the following: (A) cationically polymerizable organic substance that could be a mixture of an epoxy compound and an oxetane compound (3-ethyl-3-hydroxy methyloxetane is mentioned as an oxetane compound); (B) selected cationic photo-initiator; (C) radically polymerizable organic substance such as a polyacrylate; (D) radical photo-initiators; and (E) optional organic compounds having two or more hydroxyl groups per molecule (e.g., polyethers).

U.S. Patent No. 6,379,866 (Lawton et al) teaches a photosensitive composition comprising (A) 30-70% by weight of a cycloaliphatic diepoxide; (B) 5-35% by weight of an acrylic material selected from aromatic acrylic material or combinations thereof; (C) 10-39% by weight of an aliphatic polycarbonate diol or polytetrahydrofuran polyether polyol; (D) at least one cationic photoinitiator; and (E) at least one free-radical photoinitiator. Optionally, an oxetane compound such as 3, 3-dimethyl oxetane or 3, 3-di (chloromethyl) oxetane may be added. See column 15, lines 10 and 11 of this '866 patent. This reference states that these photosensitive compositions have the look and feel of polypropylene articles.

U.S. Patent No. 6,413,696 (Pang et al.) teaches liquid, radiation-curable compositions that contains (A) 55-90% by weight of at least one solid or liquid actinic radiation-curable and cationically polymerizable organic substance (these may include oxetane compounds, see column 6, lines 42 to 54); (B) 0.05 to 10% by weight of an actinic radiation-sensitive initiator for cationic polymerization; (C) 5% to 25% by weight of an actinic radiation-curable and radical-polymerizable organic substance; (D) 0.02 to 10% by weight of an actinic radiation-sensitive initiator for radical polymerization; and (E) 0.5 to about 40 percent by weight of at lest one solid or liquid cationic reactive modifier-flexibilizer, wherein the reactive modifier-flexibilizer is a reactive epoxy modifier, reactive vinylether modifier, reactive oxetane modifier, or mixtures thereof, and wherein the reactive modifier-flexibilizer contains at least one chain extension segment with a molecular weight of at least about 100 and not more than 2,000, wherein component (a) comprises at least one glycidylether of a polyhydric aliphatic, alicyclic or aromatic alcohol having at least three epoxy groups with epoxy equivalent weight between 90 and 800 g/equivalent and at least one solid or liquid alicyclic epoxide with epoxy equivalent weight between 80 and 330 having at least two epoxy groups with a monomer purity of at least about 80% by weight, or mixtures thereof. No specific oxetane-based modifier (e) is explicitly described in this '696 patent. See column 15, line 59 to column 17, line 53.

European Patent No. 0848294 BI (DSM N.V.; Japan Synthetic Rubber Col, LTD. and Japan Fibre Coatings, Ltd.) teaches a process for photo-fabricating a three-dimensional object by selectively curing a photo-curable composition comprising an (A) oxetane compound, (B) an epoxy compound and (C) a cationic photo-initiator wherein the oxetane compound (A) is either a compound comprising two or more oxetane rings (see claim 1) or a specifically defined oxetane compound (see claim 2).

Japanese Published Patent Application (Kokai) No. 1-0158385 (Asahi Denka Kogyo KK) teaches a resin composition for optically three-dimensional molding containing a cationic polymerizable organic materials containing an oxetane ring in its molecule.

Despite all previous attempts, there exists a need for a liquid hybrid stereolithographic composition capable of producing cured articles that possess very high reactivity along with other mechanical and chemical properties desired in stereolithographic resins. The present invention presents a solution to that need.

### BRIEF SUMMARY OF THE INVENTION

Therefore, one aspect of the present invention is directed to a liquid radiation-curable composition useful for the production of three dimensional articles by stereolithography that comprises
(A) at least one cationically polymerizing organic substance;
(B) at least one free-radical polymerizing organic substance;
(C) at least one cationic polymerization initiator;
(D) at least one free-radical polymerization initiator;
(E) at least one hydroxyl-functional compound; and
(F) at least one hydroxyl-functional oxetane compound.

Another aspect of the present invention is directed to a process for forming a three-dimensional article, said process comprising the steps:
(1) coating a thin layer of a radiation-curable composition onto a surface;
(2) exposing said thin layer imagewise to actinic radiation to form an imaged cross-section, wherein the radiation is of sufficient intensity to cause substantial curing of the thin layer in the exposed areas;
(3) coating a thin layer of the composition onto the previously exposed imaged cross-section;
(4) exposing said thin layer from step (3) imagewise to actinic radiation to form an additional imaged cross-section, wherein the radiation is of sufficient intensity to cause substantial curing of the thin layer in the exposed areas and to cause adhesion to the previously exposed imaged cross-section;
(5) repeating steps (3) and (4) a sufficient number of times in order to build up the three-dimensional article;
wherein the radiation-curable composition is that which is described above.

Still another aspect of the present invention is directed to three-dimensional articles made by the above process using the above-noted radiation-curable composition.

One preferred aspect of the present invention would be directed to a liquid radiation-curable composition useful for the production of three dimensional articles by stereolithography that comprises (A) about 30% to about 70% by weight of an alicyclic epoxide having one or two epoxy groups; (B) about 5% to about 20% of a pentafunctional (meth) acrylate; (C) about 0.02% to about 5% by weight triarylsulfonium hexafluoroantimonate; (D) about 0.01 % to about 4% by weight of 1-hydroxycyclohexylphenyl ketone; (E) about 5% to about 18% by weight of a ethoxylated or propoxylated hydroxy functional polyether; and (F) about 9% to about 17% by weight of 3-ethyl-3-hydroxymethyl-oxetane; all percentages based on the total weight of the radiation-curable composition.

It is an advantage that the liquid radiation-curable composition of the present invention provides parts with improved impact resistance and high modulus of flexure and tensile when used in a stereolithography system to form a three-dimensional object.

It is yet another advantage that the liquid radiation-curable composition of the present invention provides parts with stable properties in the presence of moisture when used in a stereolithography system to form a three-dimensional object.

It is still another advantage that the liquid radiation-curable composition of the present invention provides a resin material that permits a reliable process to produce high quality three-dimensional parts to be easily designed.

The resins of the present invention are advantageous over prior art stereolithographic resins in that they provide a resin which has the combined properties of lower viscosity, fast curing, improved green strength, and greater thermal stability in finished parts It can be used with existing stereolithographic systems and may not require any pretreating or machine adjustment before use.

Resins of the present invention are advantageous over prior art stereolithography resins in that they combine high photospeed and high accuracy. Prior art resins either have high photospeed , but give parts with low accuracy (tendency to deform during and after the stereolithography process, which is the case with radically curing acrylate systems), or, as in the case of epoxy/acrylate hybrid systems, they have lower photospeed and high accuracy. The resins of the present invention are very fast, but have the accuracy of prior art hybrid systems.

### DETAILED DESCRIPTION OF THE INVENTION

The term "(meth)acrylate" as used in the present specification and claims refers to both acrylates and methacrylates.

The term "liquid" as used in the present specification and claims is to be equated with "liquid at room temperature" which is, in general, a temperature between 5°C and 30°C.

The novel compositions herein contain, in the broadest sense, a mixture of at least one cationically polymerizable organic substances; at least one selected free-radical polymerizing organic substance; at least one cationic polymerization initiator; at least one free-radical polymerization initiator; at least one hydroxyl-functional compound and at least cationic compound. The compositions may further optionally contain other additives.

### (A) Cationically Polymerizable Organic Substances

The cationically polymerizable compound may expeditiously be an aliphatic, alicyclic or aromatic polyglycidyl compound or cycloaliphatic polyepoxide or epoxy cresol novolac or epoxy phenol novolac compound and which on average possess more than one epoxide group (oxirane ring) in the molecule. Such resins may have an aliphatic, aromatic, cycloaliphatic, araliphatic or heterocyclic structure; they contain epoxide groups or side groups or these groups form part of an alicyclic or hetrocyclic ring system. Epoxy resins of these types are known in general terms and are commercially available.

Examples of such suitable epoxy resins are disclosed in U.S. Patent No. 6,100,007.

Also conceivable is the use of liquid prereacted adducts of epoxy resins, such as those mentioned above, with hardeners for epoxy resins.

It is of course also possible to use liquid mixtures of liquid or solid epoxy resins in the novel compositions.

Examples of cationically polymerizable organic substances other than epoxy resin compounds include; oxolane compounds, such as tetrahydrofuran and 2,3-dimethyl-tetrahydrofuran; cyclic acetal compounds, such as trioxane, 1,3-dioxalane and 1,3,6-trioxan cycloctane; cyclic lactone compounds, such as β-propiolactone and ε-caprolactone; thiirane compounds, such as ethylene sulfide, 1,2-propylene sulfide and thioepichlorohydrin; and thiotane compounds, such as 1,3-propylene sulfide and 3,3-dimethylthiothane. Such alterative cationically polymerizable organic substances may be used with the epoxy resins or in their place. While oxetane compounds are generally cationically polymerizable organic substances, they are not included as such in this component (A) because they are included in component (F).

Examples of such other cationically polymerizable compounds are also disclosed in U.S. Patent No. 6,100,007.

Preferably, the cationically polymerizable compounds of the present invention constitute about 30% to 70% by weight of the radiation-curable composition.

One particularly preferred embodiment of the present invention contains a particular epoxy type of cationically polymerizing organic substances. This preferred type is an alicyclic epoxide having one or two epoxy groups. It may be used alone or with other epoxies such as difunctional or higher functional-glycidylether of polyhydric compound.

These preferred cationically polymerizing alicyclic epoxides having one or two epoxy groups include any cationically curable liquid or solid compound that may be an alicyclic polyglycidyl compound or cycloaliphatic polyepoxide which on average possesses two or more epoxide groups (oxirane rings) in the molecule. Such resins may have a cycloaliphatic ring structure that contain the epoxide groups as side groups or the epoxide groups from part of the alicyclic ring structure. Such resins of these types are known in general terms and are commercially available.

Examples of compounds in which the epoxide groups from part of an alicyclic ring system include bis(2,3-epoxycyclopentyl) ether; 2,3-epoxycyclopentyl glycidyl ether, 1,2-bis(2,3-epoxycyclopentyloxy)ethane; bis(4-hydroxycyclohexyl) methane diglycidyl ether, 2,2-bis(4-hydroxycyclohexyl) propane diglycidyl ether; 3,4-epoxycyclohexylmethyl-3',4'-epoxycyclohexanecarboxylate; 3,4-epoxy-6-methyl-cyclohexylmethyl 3,4-epoxy-6-methylcyclohexanecarboxyl ate; di(3,4-epoxycyclohexylmethyl) hexanedioate; di(3,4-epoxy-6-methylcyclohexylmethyl) hexanedioate; ethylenebis(3,4-epoxycyclohexane-carboxylate, ethanediol di(3,4-epoxycyclohexylmethyl) ether; vinylcyclohexene dioxide; dicyclopentadiene diepoxide or 2-(3,4-epoxycyclohexyl-5, 5-spiro-3,4-epoxy)cyclohexane-1,3-dioxane.

The preferred alicyclic epoxide is 3,4-epoxycyclohexylmethyl-3',4'-epoxy-cyclohexanecarboxylate which is available as Cyracure UVR 6105 or 6110.

In the most preferred embodiment, these alicyclic epoxides preferably constitute 100% by weight of the total cationic polymerizing organic substances.

For some uses, it may be desirable to use other types of epoxies or other types of cationically polymerizable organic substances with these one or more alicyclic mono- or di-epoxides. Additional types of epoxy compounds are cationically polymerizing difunctional or higher functional glycidylethers of a polyhydric compound obtainable by reacting a compound having at least two free alcoholic hydroxyl groups with a suitably substituted epichlorohydrin under alkaline conditions or in the presence of an acidic catalyst followed by alkali treatment. Ethers of this type may be derived from acyclic alcohols, such as ethylene glycol; propane-1,2-diol or poly (oxy propylene) glycols; propane-1,3-diol; butane-1,4-diol; poly (oxytetramethylene) glycols; pentane-1,5-diols; hexane-1,6-diol; hexane-2,4,6-triol; glycerol; 1,1,1-trimethylol propane; bistrimethylol propane; pentacrythritol; sorbitol and the like when reacted with polyepichlorohydrins. Such resins of these types are known in general terms and are commercially available.

The most preferred difunctional or higher functional glycidylether is trimethylol propane triglycidylether which is available as Araldite DY-T.

If used, these difunctional or higher functional glycidylethers preferably constitute from about 10% to about 50% by weight, more preferably about 15% to about 40% by weight, of the total cationic polymerizing organic substances.

### (B) Free-Radical Polymerizing Organic Substance

The free radically curable component preferably comprises at least one solid or liquid poly(meth)acrylate, for example, be di-, tri-, tetra- or pentafunctional monomeric or oligomeric aliphatic, cycloaliphatic or aromatic acrylates or methacrylates. The compounds preferably have a molecular weight of from 200 to 500.

Examples of suitable aliphatic poly(meth)acrylates having more than two unsaturated bonds in their molecules are the triacrylates and trimethacrylates of hexane-2,4,6-triol; glycerol or 1,1,1-trimethylolpropane; ethoxylated or propoxylated glycerol; or 1,1,1-trimethylolpropane; and the hydroxyl-containing tri(meth)acrylates which are obtained by reacting triepoxide compounds, for example the triglycidyl ethers of said triols, with (meth)acrylic acid. It is also possible to use, for example, pentaerythritol tetraacrylate, bistrimethylolpropane tetraacrylate, pentaerythritol monohydroxytriacrylate or -methacrylate, or dipentaerythritol monohydroxypentaacrylate or -methacrylate.

It is additionally possible, for example, to use polyfunctional urethane acrylates or urethane methacrylates. These urethane (meth)acrylates are known to the person skilled in the art and can be prepared in a known manner by, for example, reacting a hydroxyl-terminated polyurethane with acrylic acid or methacrylic acid, or by reacting an isocyanate-terminated prepolymer with hydroxyalkyl (meth)acrylates to give the urethane (meth)acrylate.

Preferably, these free radical polymerizable compounds constitute about 5% to about 20% of the radiation-curable composition.

One particularly preferred class of free radical polymerizable compounds is a trifunctional or higher functionality (meth) acrylate compound.

These optional trifunctional or higher functionality meth(acrylates) are preferably tri-, tetra- or pentafunctional monomeric or oligomeric aliphatic, cycloaliphatic or aromatic acrylates or methacrylates. Such compounds preferably have a molecular weight of from 200 to 500.

Examples of suitable aliphatic tri-, tetra- and pentafunctional (meth)acrylates are the triacrylates and trimethacrylates of hexane-2,4,6-triol; glycerol or 1,1,1-trimethylolpropane; ethoxylated or propoxylated glycerol or 1,1,1-trimethylolpropane; and the hydroxyl-containing tri(meth)acrylates which are obtained by reacting triepoxide compounds, for example the triglycidyl ethers of said triols, with (meth)acrylic acid. It is also possible to use, for example, pentaerythritol tetraacrylate, bistrimethylolpropane tetraacrylate, pentaerythritol monohydroxytriacrylate or -methacrylate, or dipentaerythritol monohydroxypentaacrylate or -methacrylate.

Examples of suitable aromatic (tri)methacrylates are the reaction products of triglycidyl ethers of trihydric phenols and phenol or cresol novolaks containing three hydroxyl groups, with (meth)acrylic acid.

These higher functional (meth) acrylates are known compounds and some are commercially available, for example from the SARTOMER Company under product designations such as SR295, SR350, SR351, SR367, SR399, SR444, SR454 or SR 9020 SR9041.

The most preferred higher functional (meth)acrylate compounds SARTOMER SR399, which is dipentaerythritol monohydroxy-pentaacrylate, or SR 9020, which is a propoxylated glycerin triacrylate.

### (C) Cationic Polymerization Initiators

In the compositions according to the invention, any type of photoinitiator that, upon exposure to actinic radiation, forms cations that initiate the reactions of the epoxy material(s) can be used. There are a large number of known and technically proven cationic photoinitiators for epoxy resins that are suitable. They include, for example, onium salts with anions of weak nucleophilicity. Examples are halonium salts, iodosyl salts or sulfonium salts, such as described in published European patent application EP 153904, sulfoxonium salts, such as described, for example, in published European patent applications EP 35969, 44274, 54509, and 164314, or diazonium salts, such as described, for example, in U.S. Patent Nos. 3,708,296 and 5,002,856. Other cationic photoinitiators are metallocene salts, such as described, for example, in published European applications EP 94914 and 94915. Other preferred cationic photoinitiators are mentioned in U.S. Patent Nos. 5,972,563 (Steinmann et al.); 6,100,007 (Pang et al.) and 6,136,497 (Melisaris et al.).

More preferred commercial cationic photoinitiators are UVI-6974, UVI-6970, UVI-6990 (manufactured by Dow Chemical Company.), CD-1010, CD-1011, CD-1012 (manufactured by Sartomer Corp.), Adekaoptomer SP-150, SP-151, SP-170, SP-171 (manufactured by Asahi Denka Kogyo Co., Ltd.), Irgacure 261 (Ciba Specialty Chemicals Corp.), Cl-2481, Cl-2624, Cl-2639, Cl-2064 (Nippon Soda Co., Ltd.), DTS-102, DTS-103, NAT-103, NDS-103, TPS-103, MDS-103, MPI-103, and BBI-103 (Midori Chemical Co., Ltd.). Most preferred are UVI-6974, CD-1010, UVI-6970, Adekaoptomer SP-170, SP-171, CD-1012, and MPI-103. The above mentioned cationic photo-initiators can be used either individually or in combination of two or more.

The most preferred cationic photoinitiator is a triarylsulfonium hexafluoroantimonate such as UVI-6974 (from Union Carbide).

The cationic photoinitiators may constitute from about 0.01 % to about 8% by weight, more preferably, from about 0.02% to about 5% by weight, of the total radiation-curable composition.

### (D) Free Radical Polymerization Initiators

In the compositions according to the invention, any type of photoinitiator that forms free radicals when the appropriate irradiation takes place can be used. Typical compounds of known photoinitiators are benzoins, such as benzoin, benzoin ethers, such as benzoin methyl ether, benzoin ethyl ether, and benzoin isopropyl ether, benzoin phenyl ether, and benzoin acetate, acetophenones, such as acetophenone, 2,2-dimethoxyacetophenone, 4-(phenylthio)acetophenone, and 1,1-dichloroacetophenone, benzil, benzil ketals, such as benzil dimethyl ketal, and benzil diethyl ketal, anthraquinones, such as 2-methylanthraquinone, 2-ethylanthraquinone, 2-tert-butylanthraquinone, 1-chloroanthraquinone, and 2-amylanthraquinone, also triphenylphosphine, benzoylphosphine oxides, such as, for example, 2,4,6-trimethylbenzoyldiphenylphosphine oxide (Lucirin® TPO), benzophenones, such as benzophenone, and 4,4'-bis(N,N'-dimethylamino)benzophenone, thioxanthones and xanthones, acridine derivatives, phenazene derivatives, quinoxaline derivatives or 1-phenyl-1,2-propanedione-2-O-benzoyloxime, 1-aminophenyl ketones or 1-hydroxyphenyl ketones, such as 1-hydroxycyclohexyl phenyl ketone, phenyl (1-hydroxyisopropyl)ketone and 4-isopropylphenyl(1-hydroxyisopropyl)ketone, or triazine compounds, for example, 4'methyl thiophenyl-1-di(trichloromethyl)-3,5 S-triazine, S-triazine-2-(stylbene)-4,6-bis-trichloromethyl, and paramethoxy stiryl triazine, all of which are known compounds.

Especially suitable free-radical photoinitiators, which are normally used in combination with a He/Cd laser, operating at for example 325 nm, an Argon-ion laser, operating at for example 351 nm, or 351 and 364 nm, or 333, 351, and 364 nm, or a frequency tripled YAG solid state laser, having an output of 351 or 355 nm, as the radiation source, are acetophenones, such as 2,2-dialkoxybenzophenones and 1-hydroxyphenyl ketones, for example 1-hydroxycyclohexyl phenyl ketone, 2-hydroxy-1-{4-(2-hydroxyethoxy)phenyl}-2-methyl-1-propane, or 2-hydroxyisopropyl phenyl ketone (also called 2-hydroxy-2,2-dimethylacetophenone), but especially 1-hydroxycyclohexyl phenyl ketone. Another class of free-radical photoinitiators comprises the benzil ketals, such as, for example, benzil dimethyl ketal. Especially an alpha-hydroxyphenyl ketone, benzil dimethyl ketal, or 2,4,6-trimethylbenzoyldiphenylphosphine oxide is used as photo-initiator.

Another class of suitable free radical photoinitiators comprises the ionic dye-counter ion compounds, which are capable of absorbing actinic rays and producing free radicals, which can initiate the polymerization of the acrylates. The compositions according to the invention that comprise ionic dye-counter ion compounds can thus be cured in a more variable manner using visible light in an adjustable wavelength range of 400 to 700 nanometers. Ionic dye-counter ion compounds and their mode of action are known, for example from published European-patent application EP 223587 and U.S. Patent Nos. 4,751,102; 4,772,530; and 4,772,541.

Especially preferred is the free-radical photoinitiator 1-hydroxycyclohexylphenyl ketone, which is commercially available as Irgacure 1-184.

The free-radical initiators constitute from about 0.01% to about 8% by weight, and most preferably, from about 0.01% to about 4 % by weight, of the total radiation curable composition.

### (E) Hydroxyl-Functional Compounds

The hydroxyl-functional compounds may be any organic material having a hydroxyl functionality of at least 1, and preferably at least 2. The material may be liquid or solid that is soluble or dispersible in the remaining components. The material should be substantially free of any groups which inhibit the curing reactions, or which are thermally or photolytically unstable.

Preferably, the hydroxyl-functional compounds are either aliphatic hydroxyl functional compounds or aromatic hydroxyl functional compounds.

The aliphatic hydroxyl functional compounds that may be useful for the present compositions include any aliphatic-type compounds that contain one or more reactive hydroxyl groups. Preferably these aliphatic hydroxyl functional compounds are multifunctional compounds (preferably with 2-5 hydroxyl functional groups) such as multifunctional alcohols, polyether-alcohols and. polyesters.

Preferably the organic material contains two or more primary or secondary aliphatic hydroxyl groups. The hydroxyl group may be internal in the molecule or terminal. Monomers, oligomers or polymers can be used. The hydroxyl equivalent weight, i.e., the number average molecular weight divided by the number of hydroxyl groups, is preferably in the range of about 31 to 5000.

Representative examples of suitable organic materials having a hydroxyl functionality of 1 include alkanols, monoalkyl ethers of polyoxyalkyleneglycols, monoalkyl ethers of alkylene-glycols, and others.

Representative examples of useful monomeric polyhydroxy organic materials include alkylene glycols and polyols, such as 1,2,4-butanetriol; 1,2,6-hexanetriol; 1,2,3-heptanetriol; 2,6-dimethyl-1,2,6-hexanetriol; 1,2,3-hexanetriol; 1,2,3-butanetriol; 3-methyl-1,3,5-pentanetriol; 3,7,11,15-tetramethyl-1,2,3-hexadecanetriol; 2,2,4,4-tetramethyl-1,3-cyclobutanediol; 1,3-cyclopentanediol; trans-1,2-cyclooctanediol; 1,16-hexadecanediol; 1,3-propanediol; 1,4-butanediol; 1,5-pentanediol; 1,6-hexanediol; 1,7-heptanediol; 1,8-octanediol; and 1,9-nonanediol.

Representative examples of useful oligomeric and polymeric hydroxyl-containing materials include polyoxyethylene and polyoxypropylene glycols and triols of molecular weights from about 200 to about 10,000; polytetramethylene glycols of varying molecular weight; copolymers containing pendant hydroxyl groups formed by hydrolysis or partial hydrolysis of vinyl acetate copolymers, polyvinylacetal resins containing pendant hydroxyl groups; hydroxyl-terminated polyesters and hydroxyl-terminated polylactones; hydroxyl-functionalized and polyalkadienes, such as polybutadiene; and hydroxyl-terminated polyethers.

Other hydroxyl-containing monomers are 1,4-cyclohexanedimethanol and aliphatic and cycloaliphatic monohydroxy alkanols.

Other hydroxyl-containing oligomers and polymers include hydroxyl and hydroxyl/epoxy functionalized polybutadiene, polycaprolactone diols and triols, ethylene/butylenes polyols, and combinations thereof. Examples of polyether polyols are also polypropylene glycols of various molecular weights and glycerol propoxylate-B-ethoxylate triol, as well as linear and branched polytetrahydrofuran polyether polyols available in various molecular weights, such as for example 250, 650, 1000, 2000, and 2900 MW.

Preferred hydroxyl functional compounds are for instance simple multifunctional alcohols, polyether-alcohols, and/or polyesters. Suitable examples of multifunctional alcohols are trimethylolpropane, trimethylolethane, pentaeritritol, di-pentaeritritol, glycerol, 1,4-hexanediol, 1,4-hexanedimethanol and the like.

Suitable polyethers include, for example, alkoxylated trimethylolpropane, or ethoxylated or propoxylated polyether compounds, polyethyleneglycol-200 or -600 and the like. One preferred example is Voranol CP 450, a glycerine propoxylated polyether triol with an average molecular weight of about 450 and available from Dow Chemical Company.

Suitable polyesters include, hydroxyfunctional polyesters from diacids and diols with optionally small amounts of higher functional acids or alcohols. Suitable diols are those described above. Suitable diacids are, for example, adipic acid, dimer acid, hexahydrophthalic acid, 1,4-cyclohexane dicarboxylic acid and the like. Other suitable ester compounds include caprolactone based oligo- and polyesters such as the trimethylolpropane-triester with caprolactone, Tone® 0301 and Tone® 0310 (Dow Chemical Company). The ester based polyols preferably have a hydroxyl number higher than about 50, in particular higher than about 100. The acid number preferably is lower than about 10, in particular lower than about 5. Preferred polyester polyols include Desmophen 850, which is a linear polyester polyol available from Bayer. Another preferred aromatic hydroxyl-functional compound is a difunctional polyester polyol such as Lupraphen 8004 which is available from BASF.

One of preferred aliphatic hydroxyl-functional compounds is trimethylolpropane, which is commercially available.

Aromatic hydroxyl functional compounds that may be useful for the present compositions include aromatic-type compounds that contain one or more reactive hydroxyl groups. Preferably, these aromatic hydroxyl functional compounds would include phenolic compounds having at least 2 hydroxyl groups as well as phenolic compounds having at least 2 hydroxyl groups which are reacted with ethylene oxide, propylene oxide or a combination of ethylene oxide and propylene oxide.

The most preferred aromatic functional compounds include bisphenol A, bisphenol S, ethoxylated bisphenol A, ethoxylated bisphenol S.

These hydroxyl functional compounds are preferably present from about 3% to about 20% by weight, more preferably, from about 5% to about 18% by weight, of the total liquid radiation-cured composition.

### (F) Hydroxy-Functional Oxetane Compounds

Any compound having at least one oxetane ring and at least one hydroxyl functionally (herein referred to as a hydroxyl-functional oxetane compound) may be employed as component (F) of the radiation-curable composition of the present invention. Preferably, these hydroxyl functional oxetane compounds contain one or two oxetane rings. Examples of such hydroxyl-functioned oxetane compounds are disclosed in U.S. Patent Nos. 5,674,922 and 5,981,616, both of which are incorporated by reference herein in their entireties. The preferred hydroxy-functional oxetane compound is a 3-ethyl-3-hydroxymethyl-oxetane.

The proportion of component (F) in the resin composition of the present invention is usually about 5 to about 20% by weight, preferably about 9 to about 17% by weight, and more preferably about 10 to about 15% by weight.

### (G) Optional Additives

If necessary, the resin composition for stereolithography applications according to the present invention may contain other materials in suitable amounts, as far as the effect of the present invention is not adversely affected. Examples of such materials include radical-polymerizable organic substances other than the aforementioned cationically polymerizable organic substances; heat-sensitive polymerization initiators, various additives for resins such as coloring agents such as pigments and dyes, antifoaming agents, leveling agents, thickening agents, flame retardants and antioxidants.

Two other preferred optional additives are pyrene and benzyldimethylamine. The former acts as a sensitizer and the latter acts as a cationic stabilizer. If used, optional additives such as these preferably constitute from about 0.001 to about 5% by weight of the total liquid radiation-curable compositions.

For some applications, it is also desirable to use fillers. Optional fillers to be used in the present invention are reactive or non-reactive, inorganic or organic, powdery, fibrous or flaky materials. Examples of organic filler materials are polymeric compounds, thermoplastics, core-shell, aramid, Kevlar, nylon, crosslinked polystyrene, crosslinked poly (methyl methacrylate), polystyrene or polypropylene, crosslinked polyethylene powder, crosslinked phenolic resin powder, crosslinked urea resin powder, crosslinked melamine resin powder, crosslinked polyester resin powder and crosslinked epoxy resin powder. Examples of inorganic fillers are glass or silica beads, calcium carbonate, barium sulfate, talc, mica, glass or silica bubbles, zirconium silicate, iron oxides, glass fiber, asbestos, diatomaceous earth, dolomite, powdered metals, titanium oxides, pulp powder, kaolin, modified kaolin, hydrated kaolin metallic filers, ceramics and composites. Mixtures of organic and/or inorganic fillers can be used.

Further examples of preferred fillers are microcrystalline silica, crystalline silica, amorphous silica, alkali alumino silicate, feldspar, woolastonite, alumina, aluminum hydroxide, glass powder, alumina trihydrate, surface treated alumina trihydrate, and alumina silicate. Each of the preferred fillers is commercially available. The most preferred filler materials are inorganic fillers, such as imsil, Novasite, mica, amorphous silica, feldspar, and alumina trihydrate. Mica as a filler is very attractive because it shows little tendency to settle out from the photocurable compositions. It has transparency to UV light, little tendency to refract or reflect incident light and it provides good dimensional stability and heat resistance.

The filler to be used for the resin composition for stereolithography according to the present invention must satisfy requirements that it hinders neither cationic nor radical polymerizations and the filled SL composition has a relatively low viscosity suitable for the stereolithography process. These fillers may be used alone or as a mixture of two or more of them depending upon the desired performance. The fillers used in the present invention may be neutral acidic or basic. The filler particle size may vary depending on the application and the desired resin characteristics. It may vary between 50 nanometers and 50 micrometers.

The filler material can optionally be surfaced treated with various compounds-coupling agents. Examples include methacryloxy propyl trimethoxy silane, beta-(3,4-epoxycyclohexyl)ethyl trimethoxy silane, gamma-glycidoxy propyl trimethoxy silane and methyl triethoxy silane. The most preferred coupling agents are commercially available from OSI Chemicals Corp. and other chemical suppliers.

The filler loading is preferably from about 0.5 to about 90%, more preferably from about 5 to about 75%, most preferably from about 5 to about 60% by weight with respect to the total weight of the filled resin composition.

### Formulation Preparation

The novel compositions can be prepared in a known manner by, for example, premixing individual components and then mixing these premixes, or by mixing all of the components using customary devices, such as stirred vessels, in the absence of light and, if desired, at slightly elevated temperature.

One preferred mixing method is to premix ingredients (A), (B), (C), (D), (E) and (F) as forming a regular stereolithographic resin composition. These ingredients are thoroughly mixed in a suitable mixer or mixers for a sufficient amount of time.

One preferred liquid radiation-curable composition useful for the production of three dimensional articles by stereolithography comprises
(A) alicyclic epoxide having one to two epoxy groups;
(B) at least one tri-, tetra- or pentafunctional monomeric or oligomeric aliphatic, cycloaliphatic or aromatic (meth)acrylate:
(C) at least one cationic polymerization initiator;
(D) at least one free radical polymerization initiator;
(E) at least one ethoxylated or propoxylated hydroxyl functional polyether; and
(F) at least one hydroxyl-functional oxetane compound.

One particularly preferred liquid radiation-curable composition that is useful for the production of three dimensional articles by stereolithography comprises:
(A) 3,4-epoxycyclohexylmethyl-3',4'-epoxycyclohexanecarboxylate;
(B) dipentaerythritol-monohydroxy pentaacrylate;
(C) at least one cationic polymerization initiator;
(D) at least one free radical polymerization initiator;
(E) glycerine propoxylated polyether triol; and
(F) 3-ethyl-3-hydroxymethyl-oxetane.

### Process of Making Cured Three-Dimensional Articles

The above-noted novel compositions can be polymerized by irradiation with actinic light, for example by means of electron beams, X-rays, UV or VIS light, preferably with radiation in the wavelength range of 280-650 nm. Particularly suitable are laser beams of HeCd, argon or nitrogen and also metal vapor and NdYAG lasers. This invention is extended throughout the various types of lasers existing or under development that are to be used for the stereolithography process, e.g., solid state, argon ion, helium cadmium lasers, and the like. The person skilled in the art is aware that it is necessary, for each chosen light source, to select the appropriate photoinitiator and, if appropriate, to carry out sensitization. It has been recognized that the depth of penetration of the radiation into the composition to be polymerized, and also the operating rate, are directly proportional to the absorption coefficient and to the concentration of the photoinitiator. In stereolithography it is preferred to employ those photoinitiators which give rise to the highest number of forming free radicals or cationic particles and which enable the greatest depth of penetration of the radiation into the compositions which are to be polymerized.

The invention additionally relates to a method of producing a cured product, in which compositions as described above are treated with actinic radiation. For example, it is possible in this context to use the novel compositions as adhesives, as coating compositions, as photoresists, for example as solder resists, or for rapid prototyping, but especially for stereolithography. When the novel mixtures are employed as coating compositions, the resulting coatings on wood, paper, metal, ceramic or other surfaces are clear and hard. The coating thickness may vary greatly and can for instance be from 0.01 mm to about 1 mm. Using the novel mixtures it is possible to produce relief images for printed circuits or printing plates directly by irradiation of the mixtures, for example by means of a computer-controlled laser beam of appropriate wavelength or employing a photomask and an appropriate light source.

One specific embodiment of the above mentioned method is a process for the stereolithographic production of a three-dimensional shaped article, in which the article is built up from a novel composition with the aid of a repeating, alternating sequence of steps (a) and (b); in step (a), a layer of the composition, one boundary of which is the surface of the composition, is cured with the aid of appropriate radiation within a surface region which corresponds to the desired cross-sectional area of the three-dimensional article to be formed, at the height of this layer, and in step (b) the freshly cured layer is covered with a new layer of the liquid, radiation-curable composition, this sequence of steps (a) and (b) being repeated until an article having the desired shape is formed. In this process, the radiation source used is preferably a laser beam, which with particular preference is computer-controlled.

In general, the above-described initial radiation curing, in the course of which the so-called green models are obtained which do not as yet exhibit adequate strength, is followed then by the final curing of the shaped articles by heating and/or further irradiation.

The present invention is further described in detail by means of the following Examples and Comparisons. All parts and percentages are by weight and all temperatures are degrees Celsius unless explicitly stated otherwise.

### EXAMPLES 1-12

The trade names of the components as indicated in the Examples 1-12 below correspond to the chemical substances recited in the following Table 1.

**TABLE 1**

| **TRADE NAMES** | **CHEMICAL DESIGNATION** |
|---|---|
| Cyracure UVR 6105 and 6110 | 3,4-epoxycyclohexylmethyl-3',4'-epoxycyclohexane-carboxylate |
| Cyracure UVR 6000 | 3-ethyl-3-hydroxymethyl-oxetane |
| TMP | Trimethylolpropane |
| Desmophen 850 | Linear polyester polyol having a hydroxyl content (DIN 53240) of 8.5%; an acid value (DIN 53402) less than 1.5 mg KOH/g and viscosity at 23°C (DIN 53 019/1) of 230 mPa.S |
| Lupraphen 8004 | Difunctional aromatic polyester polyol having a nominal molecular weight of 2000; a hydroxyl number 56 KOH/g (DIN 53 240); and a viscosity of 650 mPa.S at 75°C (DIN 53 105) |
| Voranol CP 450 | Glycerine propoxylated polyether triol with an average molecular weight of 450 |
| Sartomer SR 399 | Dipentaerythritol-monohydroxy pentaacrylate |
| Sartomer SR 9020 | Propoxylated glycerin triacrylate |
| Cyracure UVI-6974 | Triarylsulfonium hexafluoroantimonate |
| Irgacure I-84 | 1-hydroxycyclohexyl phenyl ketone |

The formulations indicated in the Examples 1-12 shown below in Table 2 were prepared by mixing the components with a stirrer at 60°C until a homogeneous composition was obtained. The physical data relating to these formulations was obtained as follows:

The viscosity of each formulation was determined at 30°C using a Brookfield viscometer.

The photosensitivity of the liquid formulations was determined on so-called WINDOWPANES^{TM} technique. In this determination, single-layer test specimens were produced using different laser energies, and the layer thicknesses obtained were measured. The plotting of the resulting layer thickness on a graph against the logarithm of the irradiation energy used gave a "working curve." The slope of this curve is termed Dp (given in mm or mils). The energy value at which the curve passes through the x-axis is termed Ec (and is the energy at which gelling of the material still just takes place; cf. P. Jacobs, Rapid Prototyping and Manufacturing, Soc. of Manufacturing Engineers, 1992, p. 270 ff.).

E6 and E12 are the energies that are required to make layer thicknesses of 6 and 12 mils, respectively. They are calculated from Dp and Ec and not absolutely necessary for the examples. They are means to compare the speed of different formulations (the lower these values, the less energy it needs to build these layer thicknesses and the faster is the laser).

GFM 10 and GFM 1 hr means green flex modulus after 10 min and after 1 hour. This gives an indication about the strength of the part after the build process in the machine. They are measured on bars of the dim. 80x4x2 mm 10 min and 1 hour after the building has been finished.

The measured post-cure mechanical properties of the formulations were determined on three-dimensional specimens produced stereolithographically with the acid of a Nd-Yag-laser laser.

The Glass Transition temperatures of each formulation were determined by the Dynamic Mechanical Analysis ("DMA") method.

The Tensile Modulus (MPa), Tensile Strength (MPa), Elongation at Break (%), were all determined according to the ISO 527 method. The Impact Resistance (notched, kJ/m²) was determined according to the ISO 179 method. The hardness of the cured resins was determined according to the Shore D test.

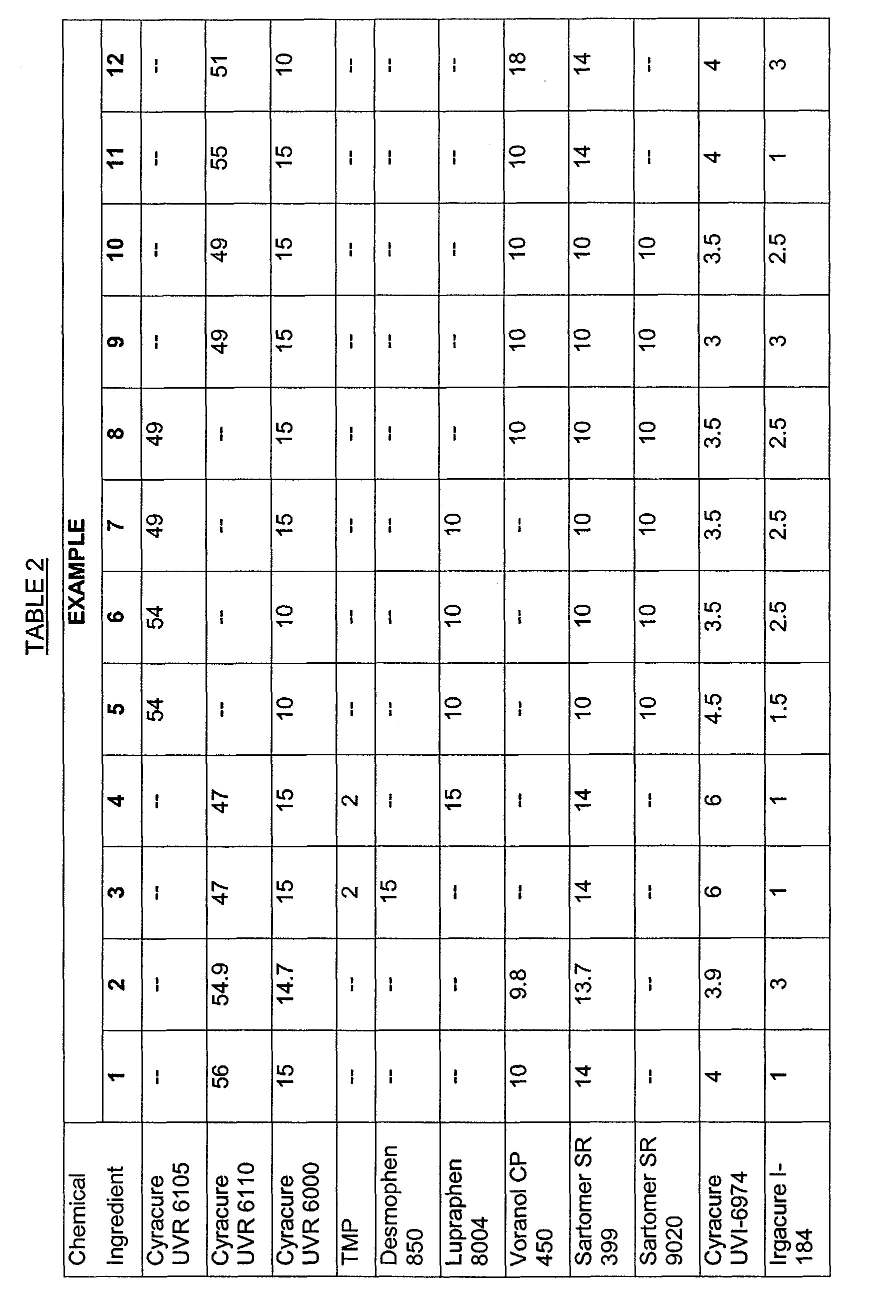

The above values represent percent by weight of each ingredient of the total composition by weight. The measured viscosity and photosensitivity of these twelve (12) formulations are shown in Table 3.

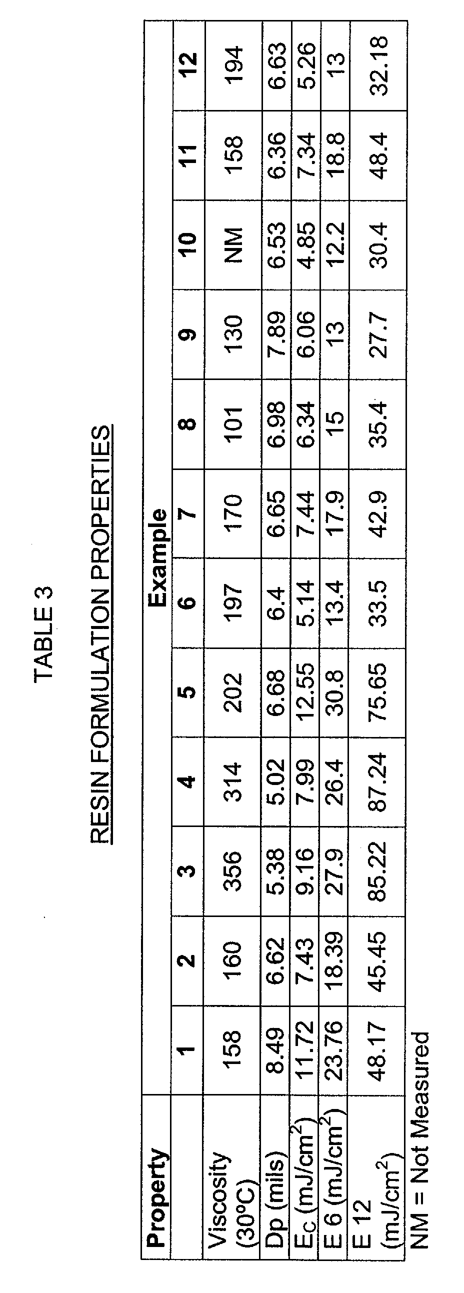

This table shows that the formulations according to this invention have very low viscosities. The high Dp-values make these resins especially suitable for the building of parts with layer thicknesses between 5 and 8 mils. In addition, the Ec ―values are low so that the resins are very fast. The E6 and E12 values indicate the energy that is needed to make layer thicknesses of 6 and 12 mils, respectively. The lower the value, the faster the resin. The measured mechanical properties for these twelve (12) formulations are shown in Table 4.

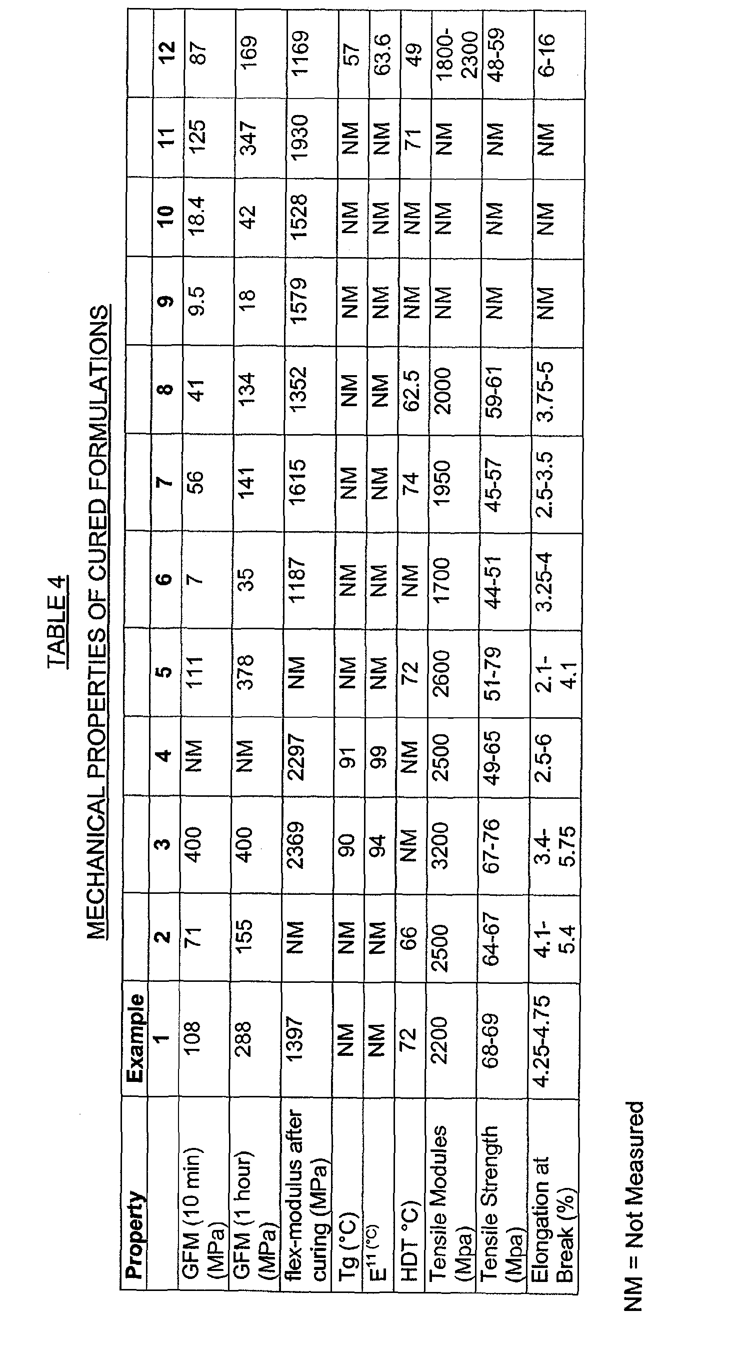

The green flex modulus is a measure of the stability of a part right after the building. It increases with time because hybrid systems continue to polymerize and build up strength even after the building process in the SLA system is finished. The higher the GFM value after 10 min. and 1 hour, the higher is the mechanical strength of a part after building and before post-curing under UV-light. The formulations of this invention have high heat deflection temperatures ( high glass transition temperatures) and good mechanical properties (high modulus and elongation at break not too low).

While the invention has been described above with reference to specific embodiments thereof, it is apparent that many changes, modifications, and variations can be made without departing from the inventive concept disclosed herein. Accordingly, it is intended to embrace all such changes, modifications and variations that fall within the spirit and broad scope of the appended claims. All patent applications, patents and other publications cited herein are incorporated by reference in their entirety.

## Claims

1. A liquid radiation-curable composition that comprises
(A) at least one cationically polymerizing organic substance;
(B) at least one free-radical polymerizing organic substance;
(C) at least one cationic polymerization initiator;
(D) at least one free-radical polymerization initiator;
(E) at least one hydroxyl-functional compound; and
(F) at least one hydroxyl-functional oxetane compound.

2. The composition of claim 1 wherein component (A) is at least an aliphatic, alicyclic or aromatic polyglycidyl compound or cyclopolyepoxide or epoxy cresol novolac or epoxy phenol novolac compound, preferably at least one alicyclic epoxide having one or two epoxy groups.

3. The composition of claim 2 wherein component (A) is 3,4-epoxycyclohexylmethyl-3',4'-epoxycyclohexane carboxylate.

4. The composition of claim 1 wherein the component (A) constitutes about 30% to about 70% by weight of the total radiation-curable composition.

5. The composition of claim 1 wherein component (B) is at least one solid or liquid poly(meth) acrylate.

6. The composition of claim 1 wherein component (B) comprises at least one trifunctional or higher functional (meth) acrylate compound.

7. The composition of claim 6 wherein component (B) is a tri-, tetra or pentafunctional monomeric or oligomeric aliphatic, cycloaliphatic, or aromatic (meth)acrylate.

8. The composition of claim 7 wherein component (B) is dipentaerythritol monohydroxy-pentaacrylate.

9. The composition of claim 1 wherein component (B) constitutes from about 5% to about 20% by weight of the total liquid radiation-curable composition.

10. The composition of claim 1 wherein component (C) is triarylsulfonium hexafluoroantimonate.

11. The composition of claim 1 wherein component (C) constitutes from about 0.1 to about 8% by weight of the total liquid radiation-curable composition.

12. The composition of claim 1 wherein component (D) is 1-hydroxycyclohexyl phenyl ketone.

13. The composition of claim 1 wherein component (D) constitutes from about 0.1 to about 8% by weight of the total liquid radiation-curable composition.

14. The composition of claim 1 wherein component (E) is present and is selected from the group consisting of trimethylolpropane, a linear polyether polyol, a difunctional aliphatic polyester and glycerine propoxylated polyether triol.

15. The composition of claim 1 wherein component (E) is present from about 3% to about 20% by weight of the total liquid radiation-curable composition.

16. The composition of claim 1 wherein component (F) is a 3-ethyl-3-hydroxymethyl-oxetane.

17. The composition of claim 1 wherein component (F) constitutes from about 5% to about 20% by weight of the total liquid radiation-cured composition.

18. A liquid radiation-curable composition according to claim 1 useful for the production of three dimensional articles by stereolithography, wherein
(A) is at least one alicyclic epoxide having one to two epoxy groups;
(B) is at least one tri-, tetra- or pentafunctional monomeric or oligomeric aliphatic, cycloaliphatic or aromatic (meth) acrylate;
(E) is glycerine propoxylated polyether triol; and,
(F) is at least one hydroxyl-functional oxetane compound resin.

19. A liquid radiation-curable composition according to claim 1 that is useful for the production of three dimensional articles by stereolithography, wherein
(A) is 3,4-epoxycyclohexylmethyl -3', 4'-epoxycyclohexanecarboxylate;
(B) is dipentaerythritol-monohydroxy pentaacrylate;
(E) is glycerine propoxylated polyether triol; and
(F) is 3-ethyl-3-hydroxymethyl-oxetane.

20. A liquid radiation-curable composition according to claim 1 useful for the production of three dimensional articles by stereolithography that comprises:
(A) about 30% to about 70% by weight of an alicyclic epoxide having one or two epoxy groups, preferably 3,4-epoxycyclohexyl methyl-3',4'-epoxycyclohexanecarboxylate;
(B) about 5% to about 20% of a pentafunctional (meth) acrylate, preferably dipentaerythritol monohydroxy pentaacrylate;
(C) about 0.02% to about 5% by weight triarylsulfonium hexafluoroantimonate;
(D) about 0.01% to about 4% by weight of 1-hydroxycyclohexylphenyl ketone;
(E) about 5% to about 18% by weight of an ethoxylated or propoxylated hydroxy functional polyether, preferably glycerine propoxylated polyether triol with an average molecular weight of about 450; and
(F) about 9% to about 17% by weight of 3-ethyl-3-hydroxymethyl-oxetane; all percentages based on the total weight of the radiation-curable composition.

21. A process for forming a three-dimensional article, said process comprising the steps:
(1) coating a thin layer of a composition onto a surface;
(2) exposing said thin layer imagewise to actinic radiation to form an imaged cross-section, wherein the radiation is of sufficient intensity to cause substantial curing of the thin layer in the exposed areas;
(3) coating a thin layer of the composition onto the previously exposed imaged cross-section;
(4) exposing said thin layer from step (3) imagewise to actinic radiation to form an additional imaged cross-section, wherein the radiation is of sufficient intensity to cause substantial curing of the thin layer in the exposed areas and to cause adhesion to the previously exposed imaged cross-section;
(5) repeating steps (3) and (4) a sufficient number of times in order to build up the three-dimensional article;
wherein the composition is that which is described in claim 1.
